# FASCICULE DE BREVET EUROPEEN

(11) **EP 0 461 014 B1**
(45) Date de publication et mention de la délivrance du brevet: **17.08.1994**
(21) Numéro de dépôt: 91401433.7
(22) Date de dépôt: 03.06.1991
(51) Int. Cl.: C23C 14/35, H01J 37/34

(54) **Installation de pulvérisation cathodique à taux élevé**
Anlage zur Kathodenzerstäubung mit hoher Geschwindigkeit
Equipment for high-rate cathodic sputtering

(30) Priorité: 08.06.1990 BE 9000576
(43) Date de publication de la demande: 11.12.1991
(73) Titulaire: SAINT GOBAIN VITRAGE INTERNATIONAL, 92400 Courbevoie (FR); GLACERIES SAINT ROCH, B-5700 Sambreville (BE)
(72) Inventeur: Devigne, Roland, B-5060 Falisolle (BE); Beaufays, Jean-Pierre, B-5190 Jemeppe S/Sambre (BE)
(74) Mandataire: Muller, René

(56) Documents cités:
- WO-A-85/02418
- DE-A- 3 834 318
- GB-A- 2 209 769
- US-A- 4 155 825
- US-A- 4 931 158

## Description

L'invention concerne une installation de pulvérisation comportant une cathode à effet magnétron à taux de pulvérisation élevé.

La pulvérisation cathodique est une technique désormais éprouvée pour l'application de couches fixes et uniformes d'un matériau de revêtement sur certains substrats. La technique de pulvérisation cathodique, qui est notamment décrite dans le brevet US-2 146 025, se réalise au moyen d'une cathode connectée à une source d'électricité, la cathode étant placée dans une enceinte en atmosphère raréfiée, en présence d'un gaz (par exemple l'argon). Une cible réalisée dans le matériau à pulvériser, fixée sur la cathode, est bombardée avec des ions énergétiques produits par la rencontre de molécules de gaz dispersées dans l'enceinte sous vide et d'électrons accélérés par un champ électrique. Ces ions gazeux sont précipités sur la cible de la cathode avec une énergie suffisante pour en arracher des particules. Le substrat à recouvrir est placé sur le trajet de ces particules et il s'y dépose une fine couche du matériau dont est faite la cible et qui consiste généralement en un métal ou un alliage ("mode métallique") ou un composé chimique de ce matériau pulvérisé formé par réaction avec un gaz réactif introduit à cet effet dans la chambre de pulvérisation ("mode réactif").

L'installation de pulvérisation cathodique suivant l'invention peut être utilisée avantageusement tant pour la pulvérisation en mode métallique que pour la pulvérisation en mode réactif et elle est d'ailleurs particulièrement avantageuse dans ce dernier cas.

Le rendement de la technique de pulvérisation cathodique était à l'origine très faible et il fallait de surcroît travailler avec un vide relativement peu poussé.

La possibilité de confiner les ions au voisinage de la cible à l'aide d'un champ magnétique a fait progresser considérablement cette technique, en augmentant de façon substantielle le taux de pulvérisation et la pureté des dépôts.

Le brevet US-4 166 018 décrit une cathode à cible plane, derrière laquelle des aimants sont disposés de façon à réaliser une zone de confinement en forme de piste ovale dans laquelle les électrons sont piégés, d'où un accroissement important du taux de collision avec les atomes gazeux, des impacts d'ions ainsi générés au voisinage de la cathode et donc du taux de pulvérisation.

On comprendra que l'on cherche encore à améliorer le rendement des techniques de pulvérisation cathodique. Le besoin d'une telle amélioration se fait plus particulièrement sentir pour la pulvérisation en mode réactif.

Lorsqu'on dépose des composés chimiques obtenus par réaction du métal de la cible avec un gaz réactif introduit dans l'enceinte, on constate, qu'en fait, le composé chimique recherché se forme aussi bien sur la cible que sur le substrat et ce, de préférence, avec les molécules excitées.

La cible se revêt en effet, par zones, d'une couche mince non conductrice ou faiblement conductrice formée par réaction du matériau de la cible avec le gaz résiduel.

D'autre part, il est difficile de régler directement la formation sur le substrat de ces mêmes composés à partir du gaz réactif et des ions, ou molécules neutres, excitées et clusters.

Par ailleurs, l'accumulation d'électrons, et particulièrement d'électrons de faible énergie, à proximité directe de la cathode, provoque la création d'une charge d'espace limitant le passage du courant de la décharge.

Il est connu que certains constructeurs utilisent dans une zone éloignée de la zone de confinement une électrode auxiliaire dite de recollection ou de drainage d'électrons, dont le rôle est de "pomper" les électrons de la décharge afin d'éviter l'accumulation d'électrons de faible énergie, peu efficaces du point de vue de l'ionisation, qui constituent également une charge d'espace limitant le courant véhiculé par les ions positifs.

La présente invention a pour but de réaliser une installation avec cathode à magnétron permettant de contrôler la répartition et les effets des particules chargées, de façon à améliorer le rendement énergétique et chimique du processus de dépôt.

Un autre but de l'invention est d'améliorer la qualité de la couche déposée sur le substrat.

Un autre but de l'invention est de réaliser une installation permettant de travailler avec un vide poussé dans l'enceinte, inférieur à la pression de travail normale d'un magnétron (quelque 0,1 Pa) d'où une plus grande pureté de la couche.

L'objet de l'invention est une installation pour le revêtement de substrats par pulvérisation cathodique, comportant une chambre de pulvérisation sous vide, un système transporteur pour supporter et déplacer les substrats au travers de la chambre et au moins une cathode constituée d'une cible dont la surface extérieure est formée d'une matière destinée à être pulvérisée, la dite cible comportant au moins une partie active, de moyens de raccordement à une source de courant électrique, d'un circuit de refroidissement de la cible, de moyens de raccordement de ce circuit de refroidissement, de moyens magnétiques de confinement comportant des aimants dont les pôles homopolaires sont reliés par des pièces polaires déterminant la surface active de la cible; le dispositif comprend, en outre, au moins une paire d'électrodes disposée à proximité de la surface des substrats, parallèlement à celle-ci, les dites électrodes étant reliées en opposition de phase à une source de tension à basse ou moyenne fréquence et étant aptes à engendrer une oscillation des particules chargées à hauteur des substrats, un injecteur de gaz réactif étant placé entre ces électrodes.

L'injecteur de gaz réactif a, avantageusement, la forme d'une rampe et comporte deux lèvres, au moins une paire d'électrodes étant située de part et d'autre de ces lèvres, le dit injecteur et les dites électrodes étant disposés à proximité du substrat, perpendiculairement au sens de déplacement imprimé par le système de transporteur aux substrats.

Avantageusement, cette source de tension à basse fréquence est apte à produire une onde carrée.

De façon avantageuse, les pièces polaires de polarité opposée de la cathode sont de forme ou de disposition dissemblable, de manière telle qu'elles confèrent aux lignes de flux magnétique franchissant l'entrefer une courbure asymétrique par rapport à un plan médian passant entre les dites pièces polaires.

Suivant une forme de variante avantageuse, la cathode comporte une cible fixe.

Selon une forme de réalisation particulière, au moins une des pièces polaires est située vers l'avant par rapport à la surface active de la cible.

Selon une forme avantageuse, au moins une des pièces polaires déborde vers l'avant par rapport à la surface active de la cible et comporte un rebord dirigé en substance vers l'autre pièce polaire.

Suivant cette forme de réalisation, au moins une des pièces polaires s'étend vers l'avant par rapport à la surface active de la cible.

Dans une forme d'exécution préférée, la pièce polaire qui s'étend vers l'avant par rapport à la surface active de la cible comporte, à sa partie la plus éloignée de la cible, un rebord dirigé en substance vers l'autre pièce polaire.

Suivant une autre forme de réalisation, l'installation est pourvue de cathodes dont la cible est de forme cylindrique, creuse, et est munie de moyens aptes à la faire tourner autour de son axe, et de moyens de refroidissement internes.

Dans la forme de réalisation ci-dessus, les moyens magnétiques sont avantageusement disposés à l'extérieur du volume de la cible cylindrique.

De façon préférée, l'installation selon l'invention comporte, près de la cible et dirigé vers celle-ci, un organe d'injection d'électrons à haute énergie. Cet organe est avantageusement un canon à électrons placé au voisinage d'une pièce polaire débouchant quasi tangentiellement à la cible.

Suivant une autre forme de réalisation, l'organe d'injection d'électrons comporte un filament chauffant fixé dans une gorge ménagée sous une pièce polaire parallèlement à l'axe de celle-ci, la face interne de cette gorge étant doublée d'un déflecteur polarisé à la tension négative de la source de pulvérisation apte à renvoyer les électrons émis par le filament sur la cible; ce filament chauffant est alimenté, de préférence, par un transformateur d'isolement délivrant une basse tension périodique.

L'installation suivant l'invention comporte également, de préférence, une électrode polarisée de manière à provoquer le déplacement des particules chargées évoluant au sein du plasma et placée à proximité d'une des pièces polaires.

Selon une forme de réalisation préférée, l'électrode est mise à la masse et est placée du côté de la pièce polaire située à l'opposé de l'inflexion maximale des lignes de force de champ magnétique dans l'entrefer.

Dans une variante de réalisation, l'électrode est mise à la masse via un circuit RLC, ce qui a pour conséquence une autopolarisation de ladite électrode.

D'autres particularités et avantages de l'invention ressortiront de la description d'une forme d'exécution particulière décrite ci-après, référence étant faite aux dessins annexés, dans lesquels :
la Fig. 1 est une vue schématique et en perspective en coupe suivant un plan perpendiculaire à l'axe d'une piste de cathode magnétron "race-track" classique;
la Fig. 2 est une vue schématique en coupe suivant un plan parallèle au sens de défilement du substrat d'une piste de cathode "belt-track" à effet magnétron monté dans une installatiion à taux de pulvérisation élevé suivant l'invention;
la Fig. 3 est une vue schématique en coupe suivant un plan perpendiculaire au plan médian de la cible d'une cathode de l'installation selon l'invention dotée d'un canon à électrons;
la Fig. 4 est une vue en coupe suivant un plan perpendiculaire au plan médian d'une cathode de type "race-track" conçue pour l'installation suivant l'invention;
la Fig. 5 est une vue schématique en coupe suivant un plan perpendiculaire à son axe d'une cathode pouvant équiper l'installation suivant l'invention et dotée d'une cible rotative à circuit magnétique externe;
la Fig. 6 est une vue en perspective, avec arrachement, d'une cathode avec électrodes de récollection suivant l'invention, et
la Fig. 7 est un graphique montrant l'évolution du taux de pulvérisation en fonction de la fréquence.

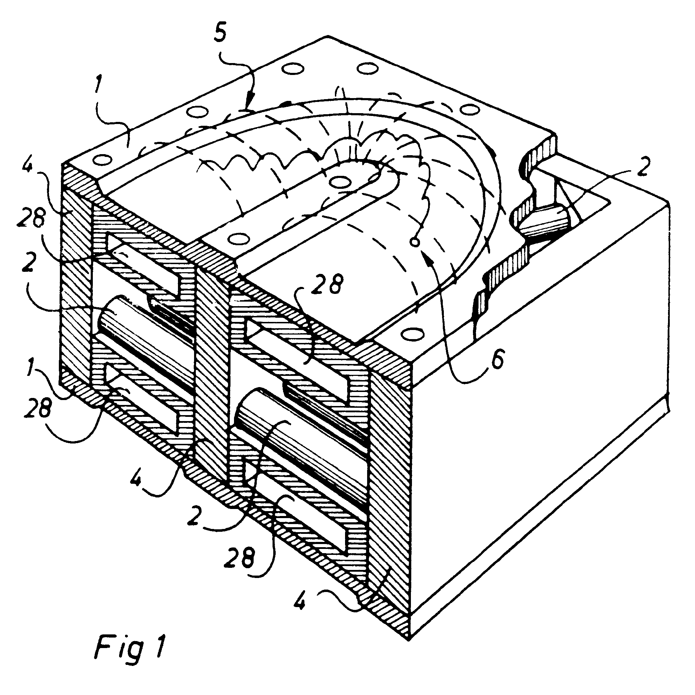

La Fig. 1 est une vue schématique en coupe suivant un plan perpendiculaire à l'axe d'une piste de cathode double "race-track" classique.

La cible est constituée de deux tôles planes 1 réalisées en matériau à pulvériser. Des aimants 2 sont placés transversalement par rapport à l'axe 3 de la cible, derrière celle-ci; les pièces polaires 4 amènent le flux magnétique jusqu'au niveau de la face arrière de chaque cible.

Les lignes de flux magnétique 5 de l'entrefer, se refermant par-dessus la cible 1, délimitent des surfaces de confinement toroïdales fermées, du fait de la forme annulaire de chaque cible.

Cette cible 1 pourrait être également constituée par une tôle de forme cylindrique refermée sur elle-même autour des moyens magnétiques 2.

Les électrons 6 confinés entre ces lignes de flux 5 "dérivent", c'est-à-dire se déplacent en tournoyant sans pouvoir s'échapper. Ces longues trajectoires accroissent fortement la probabilité que ces électrons rencontrent un atome de gaz et l'ionisent. Ces réactions se produisent toutefois préférentiellement à proximité de la surface de la cible 1, où le confinement est maximum.

Ce confinement joue aussi paradoxalement un rôle négatif, particulièrement lorsqu'on travaille en mode réactif, c'est-à-dire lorsque du gaz pouvant réagir avec la substance pulvérisée est introduit dans l'enceinte.

Lorsque l'on recherche la formation d'un composé sur le substrat, on a tout intérêt à ce que le composé recherché se forme sur le substrat lui-même ou à proximité de celui-ci. Or, la configuration de la cathode impose et favorise une densité élevée d'électrons à proximité de la cible 1 et également d'électrons secondaires thermiques.

Il se forme une "charge d'espace" limitant le courant de décharge, donc le taux de pulvérisation.

D'autre part, le composé recherché se forme aussi tien sur la cible 1 que sur le substrat. La surface de la cible 1 se couvre partiellement d'une pellicule dont la présence entrave le passage du courant de décharge.

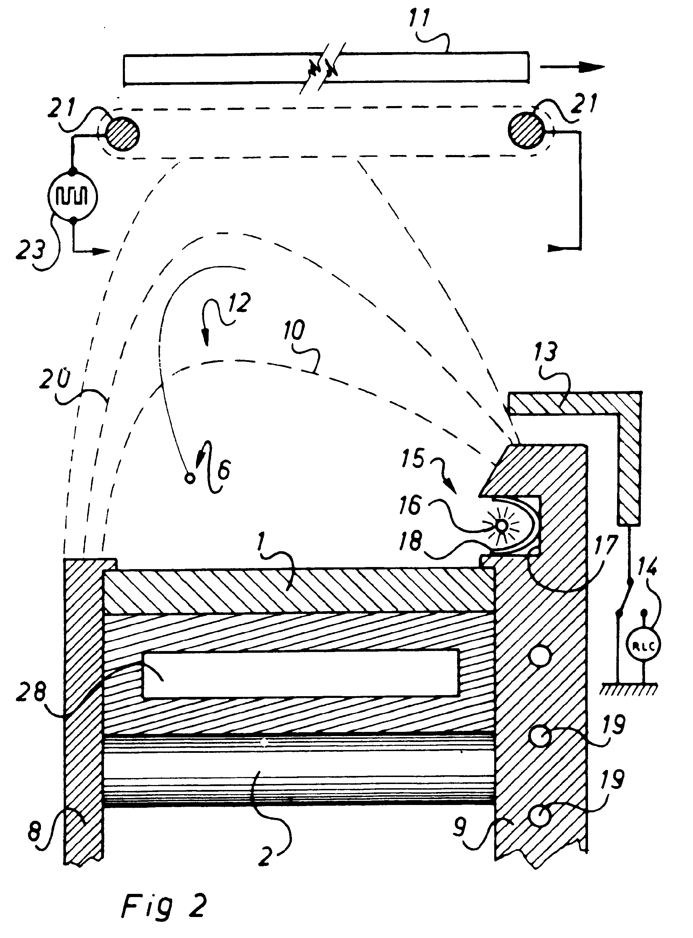

La Fig. 2 est une vue en coupe selon un plan perpendiculaire à l'axe de la cible 1 d'une cathode "belt" de type tel que décrit dans le brevet EP-018690 aménagée pour l'installation selon l'invention.

Derrière la cible 1, est monté le circuit magnétique; il est constitué de moyens magnétiques 2 (en l'occurrence des aimants) auxquels sont accolées des pièces polaires de section dissemblables 8, 9, ce qui confère au champ magnétique résultant 10 une forme dissymétrique.

Les lignes de force de ce champ 10 montrent une courbure accentuée vers le substrat 11, du côté de la pièce polaire de la plus faible dimension 8; cette configuration produit une zone 12, dite de "semi-confinement", où la probabilité d'échappement des électrons en direction du substrat est fortement accrue.

Même les électrons de relativement faible niveau énergétique peuvent ainsi diffuser vers le substrat.

Une électrode autopolarisée ou polarisée par un circuit annexe 13 est placée à hauteur de la pièce polaire de plus forte dimension 9. Cette électrode 13 favorise la diffusion des électrons en direction de la zone 12 de moindre confinement. Cette électrode 13, suivant les applications, peut être reliée à la masse, directement ou via un circuit RLC 14 ou encore être polarisée positivement ou négativement par rapport à celle-ci. Suivant l'effet recherché sur les particules évoluant au sein du plasma, on peut également injecter dans cette électrode 13 une tension périodique.

La probabilité d'ionisation et, par conséquent, le courant ionique de la cible, sont contrôlés dans la cathode du dispositif selon l'invention par injection contrôlée d'électrons d'énergie supérieure à celle nécessaire pour ioniser l'atmosphère de travail. Dans le mode de réalisation décrit à la Fig. 2, ce moyen d'injection 15 est constitué par un filament chauffant 16 maintenu dans une gorge 17 ménagée le long d'une des pièces polaires 9.

Un déflecteur 18 repousse les électrons émis en direction de la zone de confinement. Le filament 16 est alimenté à travers un transformateur d'isolement (non représenté). Un circuit de refroidissement auxiliaire 19 est prévu dans la pièce polaire 9.

Grâce à l'adjonction de cet injecteur d'électrons 15, la plage de pression de fonctionnement de l'installation peut être étendue à des pressions inférieures à un micron.

Une autre réalisation de cette injection d'électrons sera montrée à la Fig. 4. Une fois que les électrons 6 ont franchi le volume-enveloppe des trajectoires confinées 20, ils se retrouvent à proximité du substrat 11, en place utile pour provoquer l'ionisation du flux de particules neutres arrivant de la cible 1 et des atomes ou molécules de gaz réactif. Ceci a pour effet de favoriser, au niveau du substrat 11, la formation par recombinaison ou collision de particules neutres excitées très réactives.

Cet effet est amplifié dans l'installation selon l'invention par deux électrodes 21 disposées juste au-dessus du substrat 11.

Ces électrodes 21 sont montrées en coupe sur la Fig. 2, mais elles ont en réalité la forme de profilés s'étendant sur toute la largeur du substrat 11.

Ces électrodes 21 couplées et alimentées en opposition de phase sont reliées à une source de tension basse fréquence 23, émettant de préférence des ondes carrées. Les particules 6 présentes dans le plasma sont alternativement attirées, puis repoussées par chaque électrode 21.

La probabilité de collision entre les particules est donc fortement accrue à proximité directe du substrat. Le niveau énergétique des électrons thermalisés est rehaussé, les molécules présentes sont ionisées et retombent à des états excités très réactifs favorisant la formation des composés recherchés sur le substrat 11, d'où une amélioration de la composition, de l'homogénéité du dépôt et du rendement de pulvérisation.

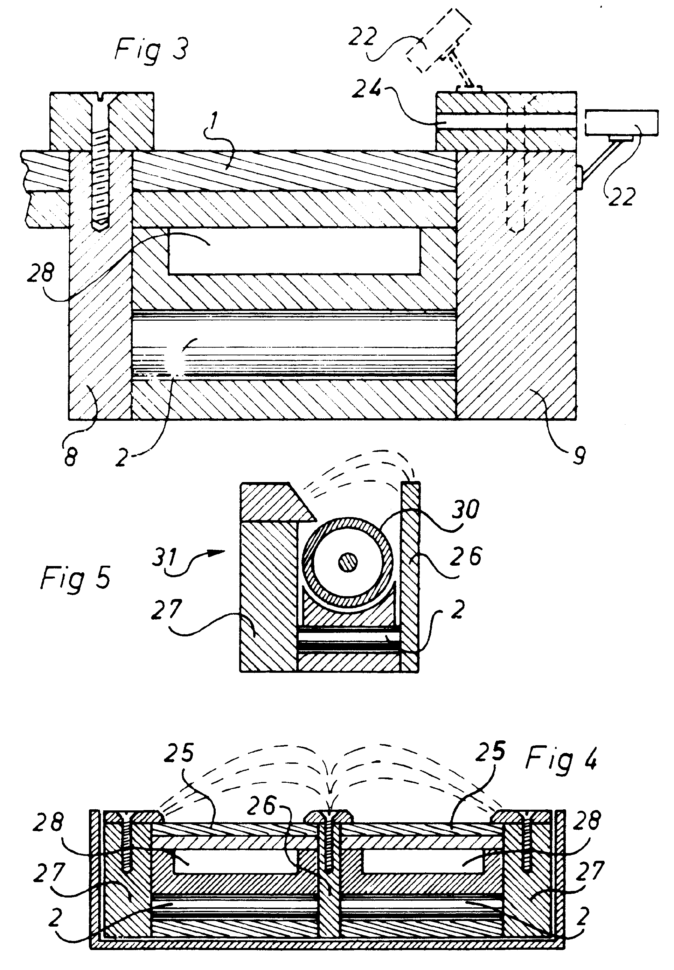

La Fig. 3 est une vue en coupe schématique selon un plan perpendiculaire au plan médian d'une piste d'une cible plane pouvant être utilisée dans l'installation, avec injection d'électrons 6 à haut niveau énergétique par un canon à électrons 22.

Le canon à électrons 22 est orienté suivant un angle prédéterminé par rapport à la cible 1 ou tangentiellement à celle-ci. Dans ce cas, un orifice 24 est ménagé au travers de la pièce polaire 9.

La Fig. 4 est une vue en coupe selon un plan perpendiculaire à l'axe d'une cathode "race-track" conçue pour l'installation selon l'invention.

La cible 1 est constituée par deux bandes longitudinales 25 raccordées à leurs extrémités pour former une piste continue. Les aimants 2 sont accolés à la face arrière de cette piste, les pôles magnétiques étant orientés de façon homopolaire vers l'intérieur et vers l'extérieur de la courbure; les pièces polaires centrales 26 sont sensiblement de section réduite par rapport aux pièces polaires externes 27, ce qui provoque une distorsion de la configuration des lignes de flux magnétique 10, favorable à l'effet de semi-confinement recherché.

La cathode est refroidie par la présence de conduits de refroidissement 28, comme dans les autres modèles illustrés.

La Fig. 5 est une vue schématique en coupe selon un plan perpendiculaire à son axe d'une cathode à cible rotative conçue pour l'installation selon l'invention et dont le circuit magnétique 29 est externe.

La cible est constituée d'une structure cylindrique 30 garnie à sa surface extérieure de matière à pulvériser. Le circuit magnétique de confinement 31 est disposé extérieurement par rapport au volume de la cible 1; il comprend des aimants 2 et des pièces polaires 26, 27 de section inégale, l'une étant de faibles dimensions et l'autre de plus fortes dimensions. Les lignes de flux magnétique 10 s'étendent entre ces pièces polaires 26, 27 de façon sensiblement parallèle à la surface de la cible 30. Ces lignes de flux magnétique 10 présentent toutefois une courbure fortement marquée en direction du substrat 11 du côté de la pièce polaire de plus faible section 26. L'évacuation vers le substrat d'électrons de relativement faible niveau énergétique favorise encore la dissipation thermique déjà extrêmement favorable avec une forme de cathode telle que décrite ici.

En outre, le circuit magnétique disposé à l'extérieur laisse la totalité du volume de la cible disponible pour le système de refroidissement.

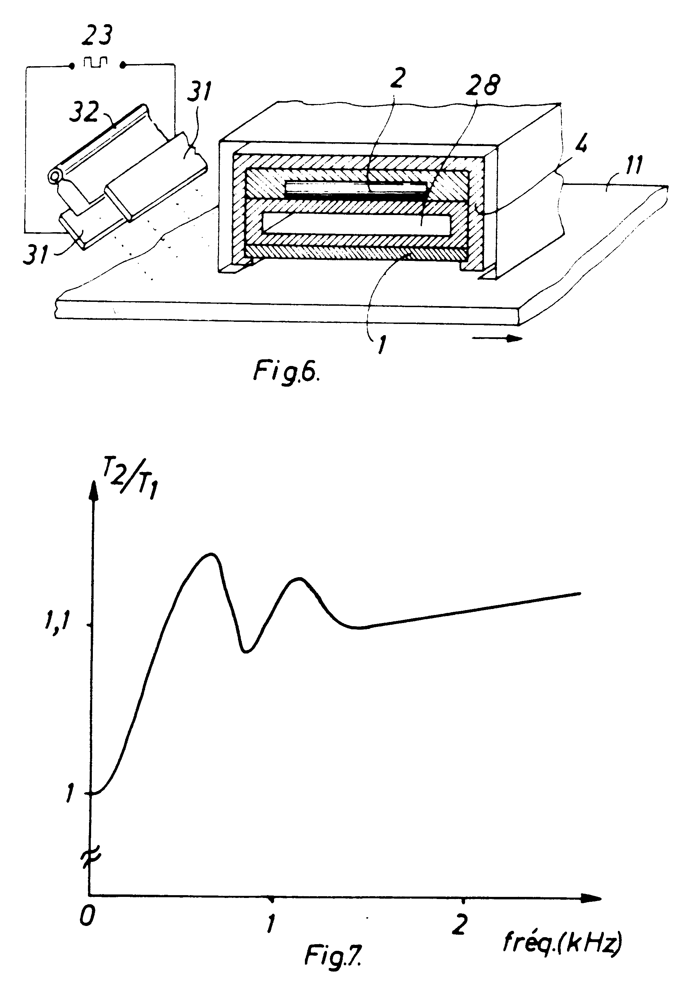

La Fig. 6 montre, en perspective, une disposition des électrodes de récollection 31 particulièrement avantageuse.

Le substrat 11 défile horizontalement sous une cathode qui est ici vue en coupe. Un injecteur de gaz réactif 32 en forme de rampe est disposé sur le côté de la cathode, parallèlement à celle-ci et à proximité du substrat 11. Des électrodes 31 en forme de barres sont fixées de part et d'autre des lèvres de l'injecteur 32 et constituent donc un passage obligé pour ces molécules de gaz réactif. Cette configuration particulière autorise un gain supérieur à 10% sur le taux de pulvérisation de la cathode. Ce gain est fonction de la matière à déposer, de la tension du signal appliqué aux électrodes et de sa fréquence. La tension peut varier, suivant la matière, entre 10 et 200 volts et la fréquence entre 100 Hz et 10 MHz.

La Fig. 7 donne, à titre d'exemple, la courbe d'accroissement du taux de pulvérisation (T2/T1) en fonction de la fréquence du signal appliqué, obtenue avec une cible d'étain et sous une tension de 10 volts crête à crête.

## Revendications

1. Installation pour revêtement de substrats par pulvérisation cathodique comportant une chambre de pulvérisation sous vide, un système de transporteur pour supporter et déplacer les substrats au travers de la chambre et au moins une cathode constituée :
d'une cible (1) dont la surface extérieure est formée d'une matière destinée à être pulvérisée, la dite cible comportant au moins une partie active,
de moyens de raccordement à une source de courant électrique,
d'un circuit de refroidissement et de moyens de raccordement à ce circuit de refroidissement,
de moyens magnétiques de confinement comportant des aimants (2), dont les pôles homopolaires sont reliés par des pièces polaires (8, 9, 26, 27) déterminant la surface active de la cible,
caractérisée en ce qu'au moins une paire d'électrodes (21) est disposée à proximité de la surface des substrats (11), parallèlement à celle-ci, les dites électrodes étant reliées en opposition de phase à une source de tension à basse fréquence (23) et étant aptes à engendrer une oscillation des particules chargées à hauteur des substrats, un injecteur de gaz réactif étant placé entre ces électrodes.

2. Installation suivant la revendication 1, caractérisée en ce que l'injecteur de gaz réactif a la forme d'une rampe et comporte deux lèvres, au moins une paire d'électrodes (21) étant située de part et d'autre de ces lèvres, le dit injecteur et les dites électrodes étant disposés à proximité du substrat, perpendiculairement au sens de déplacement imprimé par le système de transporteur aux substrats.

3. Installation suivant l'une quelconque des revendications 1 et 2, caractérisée en ce que la source de tension à basse fréquence est apte à produire une onde carrée.

4. Installation suivant l'une quelconque des revendications précédentes, caractérisée en ce que les pièces polaires du circuit magnétique de polarité opposée sont de formes ou de dispositions dissemblables, de telle manière qu'elles confèrent aux lignes de flux magnétique franchissant l'entrefer une courbure asymétrique par rapport à un plan médian passant antre les dites pièces polaires.

5. Installation suivant l'une quelconque des revendications précédentes, caractérisée en ce que la cathode (7) comporte une cible fixe (1).

6. Installation suivant la revendication 5, caractérisée en ce qu'au moins une des pièces polaires est située vers l'avant par rapport à la surface active de la cible.

7. Installation suivant la revendication 6, caractérisée en ce que cette au moins une pièce polaire qui déborde vers l'avant par rapport à la surface active de la cible comporte un rebord dirigé en substance vers l'autre pièce polaire.

8. Installation suivant l'une quelconque des revendications 1, 2, 3 et 4, caractérisée en ce que la cible de la cathode est de forme cylindrique (30), creuse, et est munie de moyens aptes à la faire tourner autour de son axe.

9. Installation suivant la revendication 8, caractérisée en ce que les moyens magnétiques (2, 8, 9, 26, 27) sont disposés à l'extérieur de la cible cylindrique.

10. Installation suivant la revendication 9, caractérisée en ce qu'au moins une des pièces polaires s'étend vers l'avant par rapport à la surface active de la cible.

11. Installation suivant la revendication 10, caractérisée en ce que la pièce polaire qui s'étend vers l'avant par rapport à la surface active de la cible comporte, à sa partie la plus éloignée de la cible, un rebord dirigé en substance vers l'autre pièce polaire.

12. Installation suivant l'une quelconque des revendications précédentes, caractérisée en ce que la cathode comporte, près de la cible et dirigé vers celle-ci, un organe (15, 22) d'injection d'électrons à haute énergie.

13. Installation suivant la revendication 12, caractérisée en ce que l'organe est un canon à électrons (22) placé au voisinage d'une pièce polaire (9) débouchant quasi tangentiellement à la cible (1).

14. Installation suivant la revendication 12, caractérisée en ce que l'organe d'injection d'électrons (15, 22) comporte un filament chauffant (16) fixé dans une gorge (17) ménagée dans une pièce polaire parallèlement à l'axe de celle-ci, la face interne de cette gorge étant garnie d'un déflecteur (18) polarisé à la tension négative de la source de pulvérisation apte à renvoyer les électrons émis par le filament vers la cible (1).

15. Installation suivant la revendication 14, caractérisée en ce que le filament chauffant (17) est alimenté par un transformateur d'isolement délivrant une basse tension périodique.

16. Installation suivant l'une quelconque des revendications précédentes, caractérisée en ce qu'une électrode (13) polarisée de manière à provoquer le déplacement des particules chargées évoluant au sein du plasma est placée à proximité d'une des pièces polaires (8, 9).

17. Installation suivant la revendication 16, caractérisée en ce que l'électrode est mise à la masse et est placée du côté de la pièce polaire située à l'opposé de l'inflexion maximale des lignes de force du champ magnétique dans l'entrefer.

18. Installation suivant la revendication 17, caractérisée en ce que l'électrode est mise à la masse via un circuit RLC (14).

## Patentansprüche

1. Vorrichtung zur Beschichtung von Substraten durch Kathodenzerstäubung, die eine Vakuumzerstäubungskammer, ein Transportsystem für das Tragen und Bewegen der Substrate durch diese Kammer und wenigstens eine Kathode umfaßt, die aus
- einem Target (1), dessen Außenfläche aus einem zu zerstäubenden Stoff besteht und das wenigstens einen aktiven Bereich enthält,
- Mitteln zum Anschluß an eine elektrische Stromquelle,
- einem Kühlkreislauf und Mitteln zum Anschluß an diesen Kühlkreislauf und
- magnetischen Ummantelungsmitteln besteht, die Magnete (2) enthalten, deren gleichsinnige Pole über Polschuhe (8, 9, 26, 27) verbunden sind, welche die aktive Fläche des Targets bilden,
**dadurch gekennzeichnet, daß** in der Nähe und parallel zu der Oberfläche der Substrate (11) wenigstens ein Paar aus Elektroden (21), die gegenphasig an eine niederfrequente Spannungsquelle (23) angeschlossen und in der Lage sind, eine Schwingung von geladenen Partikeln auf der Höhe der Substrate zu bewirken, und zwischen diesen Elektroden ein Injektor für Reaktionsgas angebracht ist.

2. Vorrichtung nach Anspruch 1, **dadurch gekennzeichnet, daß** der Injektor für Reaktionsgas rohrförmig ist und zwei Austrittsöffnungen enthält, wobei wenigstens ein Paar aus Elektroden (21) auf beiden Seiten dieser Öffnungen angebracht ist und der Injektor und die Elektroden in der Nähe des Substrats senkrecht zur Richtung der den Substraten durch das Transportsystem verliehenen Bewegung angeordnet sind.

3. Vorrichtung nach Anspruch 1 oder 2, **dadurch gekennzeichnet**, **daß** die niederfrequente Spannungsquelle eine Rechteckschwingung erzeugen kann.

4. Vorrichtung nach einem der vorhergehenden Ansprüche, **dadurch gekennzeichnet, daß** die Polschuhe des Magnetkreises mit entgegengesetzter Polarität derart verschieden geformt oder angeordnet sind, daß sie den magnetischen Flußlinien, welche den Spalt überbrücken, eine in Bezug auf eine Mittenebene, die zwischen diesen Polschuhen verläuft, asymmetrische Krümmung verleihen.

5. Vorrichtung nach einem der vorhergehenden Ansprüche, **dadurch gekennzeichnet,** **daß** die Kathode (7) ein festes Target (1) enthält.

6. Vorrichtung nach Anspruch 5, **dadurch gekennzeichnet, daß** wenigstens einer der Polschuhe in Bezug auf die aktive Fläche des Targets nach vorn gerichtet angebracht ist.

7. Vorrichtung nach Anspruch 6, **dadurch gekennzeichnet, daß** wenigstens ein Polschuh, der in Bezug auf die aktive Fläche des Targets nach vorn übersteht, einen Rand enthält, der im wesentlichen zum anderen Polschuh gerichtet ist.

8. Vorrichtung nach einem der Ansprüche 1, 2, 3 und 4, **dadurch** **gekennzeichnet**, **daß** das Target der Kathode die Form eines hohlen Zylinders (30) aufweist und mit Mitteln versehen ist, welche es sich um seine Achse drehen lassen können.

9. Vorrichtung nach Anspruch 8, **dadurch gekennzeichnet, daß** die magnetischen Mittel (2, 8, 9, 26, 27) an der Außenseite des zylindrischen Targets angeordnet sind.

10. Vorrichtung nach Anspruch 9, **dadurch gekennzeichnet, daß** wenigstens einer der Polschuhe in Bezug auf die aktive Fläche des Targets nach vorn übersteht.

11. Vorrichtung nach Anspruch 10, **dadurch gekennzeichnet, daß** der Polschuh, der in Bezug auf die aktive Fläche des Targets nach vorn übersteht, an seinem vom Target am weitesten entfernten Bereich einen Rand enthält, der im wesentlichen zum anderen Polschuh gerichtet ist.

12. Vorrichtung nach einem der vorhergehenden Ansprüche, **dadurch gekennzeichnet,** **daß** die Kathode nahe des Targets und zu ihm gerichtet ein Bauteil (15, 22) für die Zufuhr von Elektronen mit hoher Energie enthält.

13. Vorrichtung nach Anspruch 12, **dadurch gekennzeichnet, daß** das Bauteil ein Elektronenstrahler (22) ist, in der Nähe eines Polschuhs (9) angeordnet, der praktisch tangential zum Target (1) offen ist.

14. Vorrichtung nach Anspruch **12, dadurch gekennzeichnet, daß** das Bauteil (15, 22) für die Zufuhr der Elektronen einen Heizdraht (16) enthält, in einer Nut (17) befestigt, die in einem Polschuh parallel zu dessen Achse angebracht ist, wobei die Innenseite dieser Nut mit einer Ablenkeinrichtung (18) ausgerüstet ist, welche mit der negativen Spannung der Zerstäuberquelle polarisiert wird und die vom Draht emittierten Elektronen zum Target (1) senden kann.

15. Vorrichtung nach Anspruch 14, **dadurch gekennzeichnet, daß** der Heizdraht (17) von einem Isoliertransformator versorgt wird, der eine periodische Niederspannung liefert.

16. Vorrichtung nach einem der vorhergehenden Ansprüche, **dadurch gekennzeichnet, daß** eine Elektrode (13), die derart polarisiert ist, daß sie die Bewegung der im Plasma entstehenden geladenen Partikel bewirkt, in der Nähe eines der Polschuhe (8, 9) angebracht ist.

17. Vorrichtung nach Anspruch 16, **dadurch gekennzeichnet, daß** die Elektrode mit der Masse verbunden und an der Seite des Polschuhs angeordnet ist, der sich gegenüber der maximalen Ablenkung der Kraftlinien des Magnetfelds im Spalt befindet.

18. Vorrichtung nach Anspruch 17, **dadurch gekennzeichnet, daß** die Elektrode über einen RLC-Stromkreis (14) mit der Masse verbunden ist.

## Claims

1. Installation for the coating of substrates by cathodic sputtering, which has a vacuum sputtering chamber, a conveyor system for supporting and moving the substrates through the chamber and at least one cathode constituted by a target (1), whose outer surface is formed from a material which is to be sputtered, said target having at least one active part, means for connecting to an electric power supply, a circuit for cooling the target, means for connecting said cooling circuit, magnetic confinement means incorporating magnets (2), whose homopolar poles are connected by pole pieces (8, 9, 26, 27) defining the active surface of the target, characterized in that the apparatus also comprises at least one pair of electrodes (21) located in the vicinity of the surface of the substrates (11) and parallel thereto, the said electrodes being connected in phase opposition to a medium or low frequency voltage source (23) and which are able to bring about an oscillation of the charged particles level with the subtrates, a reactive gas injector being placed between these electrodes.

2. Installation according to claim 1, characterized in that the reactive gas injector is in the form of a ramp and has two lips, at least one pair of electrodes (21) being located on either side of the said lips, the said injector and the said electrodes being positioned in the vicinity of the substrate, perpendicular to the displacement direction given by the conveyor system to the substrates.

3. Installation according to either of the claims 1 and 2, characterized in that the low frequency voltage source is able to produce a square wave.

4. Installation according to any one of the preceding claims, characterized in that the pole pieces of the opposite polarity magnetic circuit have dissimilar shapes or arrangements in such a way that they give the magnetic flux lines clearing the gap an asymmetrical curvature with respect to a median plane passing between said pole pieces.

5. Installation according to any one of the preceding claims, characterized in that the cathode (7) has a fixed target (1).

6. Installation according to claim 5, characterized in that at least one of the pole pieces is located towards the front with respect to the active surface of the target.

7. Installation according to claim 6, characterized in that at least one pole piece projecting forwards with respect to the active surface of the target has a ledge directed towards the other pole piece.

8. Installation according to any one of the claims 1, 2, 3 and 4, characterized in that the cathode target is hollow cylindrical (30) and is provided with means making it rotate about its axis.

9. Installation according to claim 8, characterized in that the magnetic means (2, 8, 9, 26, 27) are located outside the cylindrical target.

10. Installation according to claim 9, characterized in that at least one of the pole pieces extends forwards relative to the active surface of the target.

11. Installation according to claim 10, characterized in that the pole piece extending forwards relative to the active surface of the target has, in its part furthest from the target, a ledge directed towards the other pole piece.

12. Installation according to any one of the preceding claims, characterized in that, close to the target and directed towards the latter, the cathode has a member (15, 22) for injecting high-energy electrons.

13. Installation according to claim 12, characterized in that the member is an electron gun (22) located in the vicinity of a pole piece (9) issuing virtually tangentially to the target (1).

14. Installation according to claim 12, characterized in that the electron injection member (15, 22) has a heating filament (16) fixed in a groove (17) made in a pole piece parallel to the axis thereof, the inner face of said groove being lined with a deflector (18) polarized to the negative voltage of the sputtering source and able to return the electrons emitted by the filament to the target (1).

15. Installation according to claim 14, characterized in that the heating filament (17) is supplied by an insulating transformer supplying a low periodic voltage.

16. Installation according to any one of the preceding claims, characterized in that an electrode (13) polarized so as to bring about the displacement of the charged particles evolving within the plasma is located in the vicinity of one of the pole pieces (8, 9).

17. Installation according to claim 16, characterized in that the electrode is earthed and is placed alongside the pole piece positioned opposite the maximum inflexion of the magnetic field force lines in the gap.

18. Installation according to claim 17, characterized in that the electrode is earthed via a RLC circuit (14).
